# EUROPÄISCHE PATENTSCHRIFT

(11) **EP 0 408 983 B1**
(45) Veröffentlichungstag und Bekanntmachung des Hinweises auf die Patenterteilung: **04.01.1995**
(21) Anmeldenummer: 90112709.2
(22) Anmeldetag: 03.07.1990
(51) Int. Cl.: H03L 7/22

(54) **Frequenzsynthesizer**
Frequency synthesizer
Synthétiseur de fréquence

(30) Priorität: 20.07.1989 DE 3924023
(43) Veröffentlichungstag der Anmeldung: 23.01.1991
(73) Patentinhaber: SIEMENS AKTIENGESELLSCHAFT, 80333 München (DE)
(72) Erfinder: Schumacher, Friedrich, Dr.-Ing., D-8000 München 71 (DE)

(56) Entgegenhaltungen:
- FR-A- 2 565 437
- GB-A- 2 080 057
- GB-A- 2 218 869
- US-A- 4 800 341

## Beschreibung

Die Erfindung bezieht sich auf einen Frequenzsynthesizer gemäß dem Oberbegriff des Patentanspruchs 1.

In vielen Funkübertragungssystemen, insbesondere aber in Radargeräten, werden Frequenzgeneratoren benötigt, die sehr schnell zwischen verschiedenen Frequenzkanälen umschalten können und dabei sehr rauscharme Signale liefern.

Für diesen Zweck werden entweder direkte oder indirekte, d.h. mit Phasenregelschleifen arbeitende Synthesizer verwendet. Die Grundlagen und Ausführungsformen solcher Synthesizer sind in dem Buch von V. Manassewitsch: "Frequency Synthesizers Theory and Design", Second Edition, 1980, John Wiley & Sons, insbesondere Seite 1 bis 50, ausführlich beschrieben. Werden zum genannten Zweck direkte Synthesizer verwendet, bei denen bekanntlich die Ausgangsfrequenz aus verschiedenen Grundfrequenzen auf direktem Wege, d.h. durch Mischen und Vervielfachen, zusammengesetzt wird, so sind die Nebenlinien und das Rauschen weitab vom Träger unbefriedigend. Im Aufsatz von D. Brewerton N. Urbaneta: "Synthesizer primer: Defining the elements of good design", aus der Zeitschrift "Microwaves & RF", Juni 1984, Seiten 79 bis 86 und Seite 124 und 125 werden im Zusammenhang mit indirekten Synthesizern Vorschläge gemacht, wie man schnell schaltende phasengesteuerte Regelschleifen (High Speed Multiloops) mit guten Leistungsmerkmalen realisieren kann. Wie aus der letztgenannten Literaturstelle zu entnehmen ist, ist das Phasenrauschen einer phasengesteuerten Regelschleife (PLL) vom Teilerverhältnis innerhalb der Regelschleife abhängig. Bei einem Teilerverhältnis von 1 nimmt das Phasenrauschen einen minimalen Wert an. Erzeugt man das Frequenzablagesignal (Fehlersignal) durch Mischen, so ist darauf zu achten, daß die Vervielfachungsfaktoren im Referenzzweig möglichst klein bleiben, da mit jeder Vervielfachung um den Faktor N das Rauschen um N² erhöht wird. Dies geht auch aus dem genannten Buch von V. Manassewitsch, insbesondere Seite 119 bis 124 hervor.

Der Erfindung liegt die Aufgabe zugrunde, unter Anwendung des Prinzips des indirekten Synthesizers und der sich dadurch ergebenden Vorteile bezüglich der Nebenlinien und des Rauschverhaltens einen Frequenzsynthesizer zu schaffen, der die Frequenzwechsel-Schaltgeschwindigkeit von direkten Synthesizern nahezu erreicht.

Gemäß der Erfindung wird diese Aufgabe durch die im kennzeichnenden Teil des Patentanspruchs 1 angegebenen Merkmale gelöst. Die Vorteile des Frequenzsynthesizers nach der Erfindung bestehen darin, daß keine Frequenzteiler in der Regelschleife verwendet werden und die Vervielfachungsfaktoren im Referenzzweig klein bleiben. Dies führt zu sehr guten Rauscheigenschaften. Zudem erlaubt der Frequenzsynthesizer nach der Erfindung trotz kleiner Frequenzinkremente die Verwendung hoher Referenzfrequenzen und entsprechend hoher Regelschleifen-Bandbreiten. Dadurch werden extrem kurze Schaltzeiten (< 10 µsec) möglich. Eine weitere wesentliche, sich aus der Art der Frequenzaufbereitung ergebende Eigenschaft des Frequenzsynthesizers nach der Erfindung besteht darin, daß trotz hoher Regelschleifen-Bandbreiten außer der Referenzfrequenz, die leicht auszufiltern ist, keine störenden Nebenlinien auftreten. Der Frequenzsynthesizer nach der Erfindung erfüllt somit alle an einen Synthesizer zu stellenden Anforderungen in optimaler Weise.

Ein nach der Erfindung aufgebauter Frequenzsynthesizer ist somit geeignet für eine rauscharme Trägerversorgung, die zu sehr raschem Frequenzwechsel fähig ist, was eine Verwendung insbesondere in frequenzagilen Radargeräten ermöglicht.

Weitere vorteilhafte Maßnahmen und Weiterbildungen der Erfindung sind in den Unteransprüchen angegeben.

Im folgenden wird die Erfindung anhand von Zeichnungen erläutert. Es zeigen
- Fig. 1: das Blockschaltbild eines Ausführungsbeispiels des Frequenzsynthesizers nach der Erfindung,
- Fig. 2: ein Linienfrequenzspektrum der Zwischenfrequenzen sowie des Kammlinienspektrums für die Rastermischstufe 14 in einer PLL-Schleife 19,
- Fig. 3: das Schaltbild eines im Frequenzsynthesizer nach der Erfindung verwendeten spannungsgesteuerten Oszillators VCO 11,
- Fig. 4: die räumliche Anordnung dieses spannungsgesteuerten Oszillators als Baugruppe.

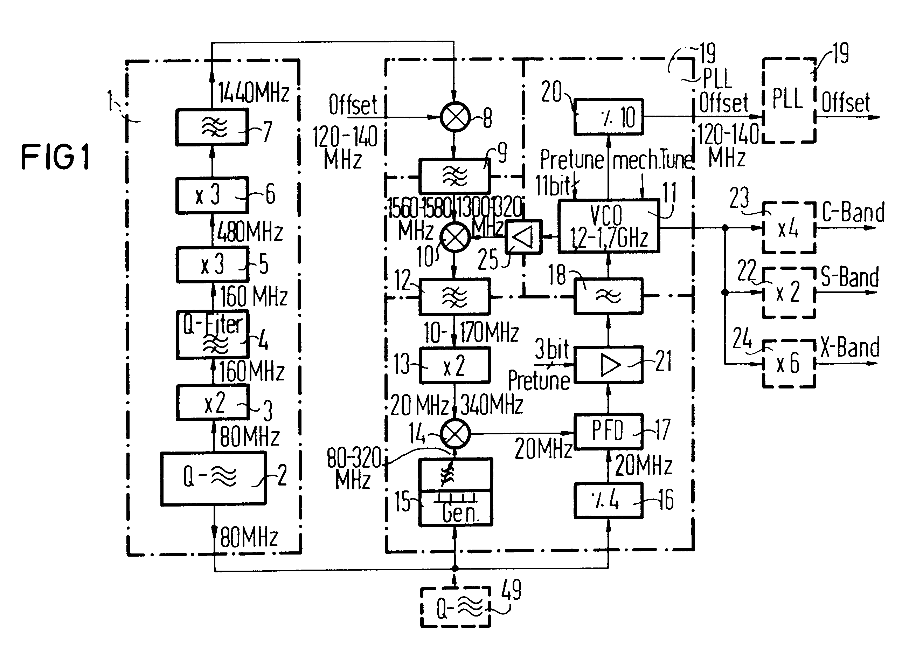

Zunächst wird das in Fig. 1 dargestellte Blockschaltbild eines Ausführungsbeispiels des Frequenzsynthesizers nach der Erfindung beschrieben. Dieser Frequenzsynthesizer dient der Erzeugung verschiedener Frequenzen im Mikrowellenbereich. Er weist einen Referenzfrequenzzweig 1 und mehrere nach dem "Frequenzteiler- und Mischprinzip" (divide and mix) kaskadierte phasengesteuerte Regelkreise auf, die jeweils ein PLL (Phase Locked Loop)-Segment 19 bilden. Im Hochfrequenz-Referenzfrequenzzweig 1 wird ausgehend von einem sehr guten Quarzoszillator 2 mit der Frequenz 80 MHz ein Hochfrequenz-Referenzsignal von der Frequenz 1440 MHz erzeugt. Nach einer Frequenzverdoppelung der Grundfrequenz von 80 MHz in einem Frequenzvervielfacher 3 ist ein Quarzfilter 4 zwischengeschaltet, welches das Rauschen des Oszillators weiter verringert. Nach zwei weiteren Vervielfacherstufen 5 und 6, die jeweils um den Faktor 3 vervielfachen, sorgt ein schmales Bandfilter 7 dafür, daß im Hochfrequenz-Referenzsignal die Nebenlinien genügend unterdrückt werden.

Das nachfolgende PLL-Segment 19 ist beliebig oft nach dem bekannten "divide and mix"-Prinzip kaskadierbar. Bei einem dekadischen Frequenzsynthesizer würde also jedes PLL-Segment 19 eine Dezimalstelle realisieren. Die Offset-Frequenz kann aus der vorhergehenden PLL-Regelschleife durch Frequenzteilung gewonnen werden. Beim dekadischen Synthesizer erfordert dies einen Frequenzteiler 20 mit dem Teilerverhältnis 1 : 10. Da durch die Frequenzteilung sowohl das Rauschen als auch Nebenlinien des vorhergehenden PLL-Segments 19 reduziert werden (Faktor 1/N²), kann zur Erzeugung der Offset-Frequenz anstelle im Wege der Ableitung über ein PLL-Segment 19 auch ein direkter digitaler Synthesizer DDS verwendet werden.

Nach der Mischung des Hochfrequenz-Referenzsignals von 1440 MHz mit der Offset-Frequenz von 120 bis 140 MHz in einer Offset-Mischstufe 8 wird die Summen- oder Differenzfrequenz, die mittels eines Bandfilters 9 ausgesiebt wird, mit der Ausgangsfrequenz eines spannungsgesteuerten Oszillators VCO 11 mittels einer Zwischenfrequenz-Mischstufe 10 in die Zwischenfrequenz-Ebene gemischt. Wird im Bandfilter 9 die Summenfrequenz ausgesiebt, so werden der Zwischenfrequenz-Mischstufe 10 am einen Eingang 1560 bis 1580 MHz eingegeben, wogegen diesem Eingang bei der Aussiebung der Differenzfrequenz 1300 bis 1320 MHz zugeführt werden. Welcher Fall günstiger ist, hängt davon ab, bei welcher Frequenz der Oszillator VCO 11 betrieben wird. Ein Zwischenfrequenz-Filter 12 sorgt für Nebenlinienfreiheit. In der Zwischenfrequenz-Ebene existieren nun, auch bei kleinen Frequenzinkrementen, keine Spektrallinien mehr, die nicht Harmonische der Referenzfrequenz wären (synchrone Zwischenfrequenzebene). Dadurch ist sichergestellt, daß im digitalen Phasen-Frequenz-Detektor 17 des PLL-Segments 19 auch bei hohen Phasenregelschleifen-Bandbreiten keine Nebenlinien entstehen.

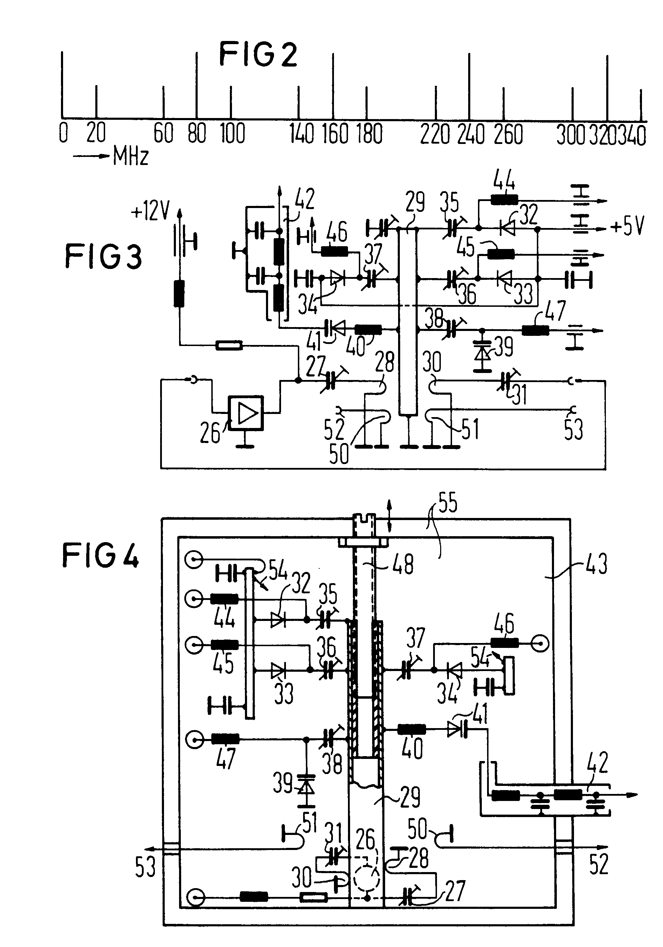

Das Zwischenfrequenz-Signal wird im Anschluß an die Zwischenfrequenz-Filterung im Filter 12 einem Frequenzvervielfacher 13 zugeführt und dort hinsichtlich seiner Frequenz verdoppelt. Danach wird das eigentliche Zwischenfrequenz-Signal mit einer aus einem Linienrasterspektrum (Comb Line Spectrum) ausgefilterten Frequenz in einer Rastermischstufe 14 gemischt. Das Linienspektrum weist einen Linienabstand von 80 MHz auf und wird mittels eines Kammliniengenerators 15 aus der Grundfrequenz des Quarzoszillators 2 abgeleitet. Dadurch entsteht bei Zwischenfrequenzen von 60 MHz, 100 MHz, 140 MHz, 180 MHz, 220 MHz, 260 MHz, 300 MHz, 340 MHz durch Mischung mit den Comb Line Frequenzen 80 MHz, 160 MHz, 240 MHz, 320 MHz eine Mischfrequenz von 20 MHz. Die genannten Comb Line Frequenzen und Zwischenfrequenzen sind als Linien in Fig. 2 dargestellt. Die Mischfrequenz von 20 MHz enthält die Frequenzablage des spannungsgesteuerten Oszillators VCO 11 und wird Fehlersignal genannt. Dieses Fehlersignal wird dem Phasen-Frequenz-Detektor 17 zugeführt. In dem Phasen-Frequenz-Detektor 17 wird dieses Fehlersignal mit einem Referenzsignal verglichen, das aus der Grundfrequenz des Quarzoszillators 2 durch Frequenzteilung mittels eines Frequenzteilers 16 mit dem Teilerverhältnis 1 : 4 abgeleitet wird. Das Referenzfrequenzsignal für den Phasen-Frequenz-Detektor hat somit exakt die Frequenz von 20 MHz. Im Phasen-Frequenz-Detektor 17 wird aufgrund des Vergleichs eine Regelspannung erzeugt, die dann über einen Regelverstärker 21 und einen Schleifentiefpaß 18 den spannungsgesteuerten Oszillator VCO 11 steuert. Ist die nach dem Frequenzvervielfacher 13 vorliegende Zwischenfrequenz selbst 20 MHz, so wird diese dem Phasen-Frequenz-Detektor 17 direkt zugeführt. Somit kann der spannungsgesteuerte Oszillator VCO 11 alle 20 MHz einrasten. Wird ein anderes Raster gewünscht, das nicht direkt aus der Grundfrequenz des Quarzoszillators 2 ableitbar ist, so kann ein eigener quarzstabilisierter Rasteroszillator 49 verwendet werden, der gegebenenfalls mit dem Quarzoszillator 2 synchronisiert werden kann. Auf welcher von diesen Rasterfrequenzen der spannungsgesteuerte Oszillator VCO 11 einrastet, wird durch eine Vorabstimmung (Pretune) bestimmt. Dadurch ist der Frequenzbereich des spannungsgesteuerten Oszillators VCO 11 ohne Hardwareänderung bei gleicher Quarzgrundfrequenz verschiebbar, was Voraussetzung für ein modulares Trägerversorgungskonzept ist.

Die Ausgangsfrequenz des spannungsgesteuerten Oszillators VCO 11 wird entweder mittels eines Frequenzteilers 20 geteilt (typische Teilerverhältnisse sind 8, 10 oder 16; im Ausführungsbeispiel ist das Teilerverhältnis 10) und als Offset-Frequenz für das nächste PLL-Segment 19 benutzt oder sie stellt direkt die Lokaloszillator-Frequenz dar. Für die Trägerversorgung von Radargeräten in höheren Frequenzbändern, z.B. S-, C- und X-Band, können Frequenzvervielfacher 22, 23, 24 nachgeschaltet werden. Im Wege der Zuführung des Ausgangssignals des spannungsgeregelten Oszillators VCO 11 zur Zwischenfrequenz-Mischstufe 10 ist noch ein Hochfrequenzverstärker 25 als Trennverstärker angeordnet.

Die Schaltgeschwindigkeit von kaskadierten Phasenregelschleifen beim Frequenzwechsel bleibt sehr hoch, weil alle Phasenregelschleifen (PLL) mit hohen Referenzfrequenzen bzw. Schleifenbandbreiten arbeiten.

Die Mischung in der Rastermischstufe 14 kann auch ohne vorherige Frequenzverdopplung im Frequenzvervielfacher 13 vorgenommen werden, wenn der Rasterlinienabstand 40 MHz beträgt. Die Referenzfrequenz im Phasen-Frequenz-Detektor 17 ist dann 10 MHz. Es ist auch möglich, eine Frequenzverdoppelung zwischen der Rastermischstufe 14 und dem Phasen-Frequenz-Detektor 17 vorzusehen.

Der Regelverstärker 21 wird in vorteilhafter Weise ebenfalls durch eine Vorabstimmung (Pretune) bezüglich seiner Verstärkung eingestellt.

Fig. 3 zeigt den spannungsgesteuerten Oszillator VCO 11 in Schaltbildform und Fig. 4 diesen Oszillator 11 als Baugruppe 43. Der spannungsgesteuerte Oszillator ist eine, einen monolitisch integrierten Hochfrequenz-Verstärker (26) aufweisende Schaltung, in deren von ihrem Ausgang zu ihrem Eingang führenden, eine Resonanzschaltung bildenden Mitkopplungszweig der Reihe nach ein Kondensator 27, ein über eine induktive Einkoppelschleife 28 angekoppelter, mittels einer Schraube 48 mechanisch abstimmbar ausgebildeter Koaxialresonator mit einem Innenleiter 29 und ein weiterer an den Innenleiter 29 über eine Auskoppelschleife 30 angekoppelter Kondensator 31 liegen. Mittels der Schraube 48 läßt sich ein im Innenleiter 29 integrierter Tauchkondensator und damit die Frequenz des Oszillators mechanisch abstimmen. Zur elektronischen Vorabstimmung (Pretune) sind an der Außenwand des Tauchkondensators 29 an geeigneten Positionen mehrere, jeweils über eine PIN-Diode 32, 33, 34 ein- und abschaltbare Trimmerkondensatoren 35, 36, 37 angeschlossen. Die Steuerspannung für die PIN-Dioden 32, 33, 34 werden über Drosseln 44, 45 und 46 zugeführt. Außerdem ist an die Außenwand des Innenleiters 29 mit einem Ende noch ein Trimmerkondensator 38 angeschlossen, an dessen anderem Ende eine durch eine Vorabstimmspannung gesteuerte, erste Varaktordiode 39 liegt. Die Steuerspannung für die erste Varaktordiode 39 wird über eine Drossel 47 zugeführt. An die Außenwand des Innenleiters 29 ist schließlich noch über eine Drosselinduktivität 40 eine zweite Varaktordiode 41 angeschlossen, die von der über das Schleifentiefpaßfilter kommenden Regelspannung des Phasen-Frequenz-Detektors beaufschlagt wird. Das Schleifen-Tiefpaßfilter ist als Durchführungsfilter 42 ausgeführt und ist somit in die Baugruppe 43 des spannungsgesteuerten Oszillators integriert. Das Material für den Innenleiter 29 ist so gewählt, daß der Temperaturgang des Tauchkondensators, den der Innenleiter 29 zusammen mit der an einem den Außenleiter des Koaxialresonators bildenden Gehäuse 55 befestigten Abstimmschraube 48 bildet, den Temperaturgang des Koaxialresonators kompensiert. Eine solche Kompensation kann z.B. erreicht werden, wenn das Gehäuse 55 aus Aluminium und der Innenleiter 29 aus Invar besteht.

Mit 50 und 51 sind zwei an Ausgänge 52 bzw. 53 herangeführte Auskoppelschleifen der spannungsgesteuerten Oszillator-Baugruppe 43 bezeichnet. Durch die beiden Pfeile 54 soll eine leitende Verbindung über die Bodenplatte des Gehäuses 55 angedeutet werden.

## Patentansprüche

1. Frequenzsynthesizer zur Erzeugung verschiedener Frequenzen im Mikrowellenbereich mit einem Referenzfrequenzzweig und einem oder mehreren nach dem "Frequenzteiler und Misch"-Prinzip (divide and mix) kaskadierten phasengesteuerten Regelkreisen, die jeweils ein PLL-Segment bilden und eine Offset-Mischstufe zur Mischung einer stabilen Offset-Frequenz mit einer im Referenzfrequenzzweig von einer stabilen Quarzoszillator-Grundfrequenz abgeleiteten Referenzfrequenz, einen Phasen-Frequenz-Detektor zum Vergleich eines Fehlersignals mit einer ebenfalls von der stabilen Grundfrequenz abgeleiteten Frequenz und einen spannungsgesteuerten Oszillator aufweisen, dem als Regelspannung die Ausgangsspannung des Phasen-Frequenz-Diskriminators über einen Schleifentiefpaß zugeführt und von dem die Ausgangsfrequenz sowie gegebenenfalls nach Führung über einen Frequenzteiler die Offset-Frequenz für den phasengesteuerten Regelkreis des nächstfolgenden PLL-Segments abgeleitet wird,
**dadurch gekennzeichnet**,
daß der Referenzfrequenzzweig (1) im Anschluß an den die stabile Grundfrequenz erzeugenden Quarzoszillator (2) der Reihe nach einen ersten Frequenzvervielfacher (3), ein Quarzfilter (4), einen oder mehrere in Reihe geschaltete weitere Frequenzvervielfacher (5, 6) und ein schmalbandiges, für die Referenzfrequenz bemessenes Bandfilter (7) aufweist, daß am Ausgang der Offset-Mischstufe (8) der Eingang eines entweder für die Summen- oder Differenzfrequenz ausgelegten Bandfilters (9) angeschlossen ist, dessen Ausgang mit einem der beiden Eingänge einer Zwischenfrequenz-Mischstufe verbunden ist, deren anderem Eingang das Ausgangssignal des spannungsgesteuerten Oszillators (11) zugeführt wird, daß der Ausgang der Zwischenfrequenz-Mischstufe unter Zwischenschaltung eines Zwischenfrequenz-Filters (12) direkt oder über einen Frequenzvervielfacher (13) mit einem den Zwischenfrequenz-Eingang darstellenden Eingang einer Rastermischstufe (14) verbunden ist, an deren anderem Eingang ein Signal, das aus einem vom Quarzoszillator (2) oder einem Rasteroszillator (49) mittels eines Kammliniengenerators (15) abgeleiteten Kammlinienspektrum mit einem der Grundfrequenz entsprechenden Spektrallinienabstand ausgefiltert wird, liegt, daß vom Ausgang der Rastermischstufe das mit der Mischfrequenz der der Rastermischstufe zugeführten Signale in einer synchronen Zwischenfrequenz-Ebene schwingende Fehlersignal als erstes Eingangssignal dem einen Eingang und ein vom Quarzoszillator über einen Frequenzteiler abgeleitetes und damit bezüglich der Grundfrequenz bzw. der Rasterozsillatorfrequenz in einem starren Teilerverhältnis stehendes Referenzsignal dem zweiten Eingang des Phasen-Frequenz-Detektors (17) zum Vergleich zugeführt werden, und daß der spannungsgesteuerte Oszillator, dem die sich aufgrund des Vergleichs ergebende Ausgangsspannung des Phasen-Frequenz-Detektors als Regelspannung über den Schleifentiefpaß (18) zugeführt wird, vorabstimmbar (pretune) ausgebildet ist, derart, daß sich diejenige der Kammlinienfrequenzen, auf die die Rastermischstufe jeweils einrasten soll, voreinstellen läßt.

2. Frequenzsynthesizer nach Anspruch 1,
**dadurch gekennzeichnet**,
daß die Offset-Frequenz anstelle im Wege der Ableitung über ein PLL-Segment (19) von einem direkten digitalen Synthesizer erzeugt wird.

3. Frequenzsynthesizer nach Anspruch 1 oder 2,
**dadurch gekennzeichnet**,
daß alle PLL-Segmente (19) gleich aufgebaut sind.

4. Frequenzsynthesizer nach einem der vorhergehenden Ansprüche,
**dadurch gekennzeichnet**,
daß das Teilerverhältnis der Frequenzteiler (20) für die entsprechend dem "Frequenzteiler- und Misch"-Prinzip (divide and mix) kaskadierten phasengesteuerten Regelkreise 1 : 10 beträgt, so daß sich ein dekadischer Frequenzsynthesizer ergibt, in dem also jedes PLL-Segment (19) eine Dezimalstelle realisiert.

5. Frequenzsynthesizer nach einem der vorhergehenden Ansprüche,
**dadurch gekennzeichnet**,
daß dem Schleifentiefpaß (18) ein in der Verstärkung voreinstellbarer (Pretune) Regelverstärker (21) vorgeschaltet ist.

6. Frequenzsynthesizer nach einem der vorhergehenden Ansprüche,
**dadurch gekennzeichnet**,
daß das Zwischenfrequenzsignal für den Fall, daß es frequenzmäßig mit dem Fehlersignal übereinstimmt, unmittelbar, also ohne Einleitung an den Zwischenfrequenz-Eingang der Rastermischstufe (14), an den ersten Eingang des Phasen-Frequenz-Detektors (17) geführt wird.

7. Frequenzsynthesizer nach einem der vorhergehenden Ansprüche,
**dadurch gekennzeichnet**,
daß das Ausgangssignal des spannungsgeregelten Oszillators (11) jeweils noch über einen oder mehrere zueinander parallel angeordnete Frequenzvervielfacher (22, 23, 24) geführt ist, so daß sich Trägerfrequenzen in höheren Frequenzbändern erzeugen lassen.

8. Frequenzsynthesizer nach einem der vorhergehenden Ansprüche,
**dadurch gekennzeichnet**,
daß im Referenzfrequenzzweig (1) der erste Frequenzvervielfacher (3) ein Frequenzverdoppler ist.

9. Frequenzsynthesizer nach einem der vorhergehenden Ansprüche,
**dadurch gekennzeichnet**,
daß im Referenzfrequenzweig (1) nach dem Quarzfilter (4) zwei weitere Frequenzvervielfacher (5, 6) vorgesehen sind, die jeweils als Frequenzverdreifacher ausgebildet sind.

10. Frequenzsynthesizer nach einem der vorhergehenden Ansprüche,
**dadurch gekennzeichnet**,
daß im Wege der Zuführung des Ausgangssignals des spannungsgeregelten Oszillators (11) zur Zwischenfrequenz-Mischstufe (10) noch ein Hochfrequenzverstärker (25) als Trennverstärker angeordnet ist.

11. Frequenzsynthesizer nach einem der vorhergehenden Ansprüche,
**dadurch gekennzeichnet**,
daß der spannungsgesteuerte Oszillator (11) eine einen monolithisch integrierten Hochfrequenz-Verstärker (26) aufweisende Schaltung ist, in deren von ihrem Ausgang zu ihrem Eingang führenden, eine Resonanzschaltung bildenden Mitkopplungszweig der Reihe nach ein Kondensator (27), ein über eine induktive Einkoppelschleife (28) angekoppelter, mechanisch abstimmbar ausgebildeter Koaxialresonator mit einem Innenleiter (29) und ein weiterer, an den Innenleiter über eine Auskoppelschleife (30) angekoppelter Kondensator (31) liegen, daß zur elektronischen Vorabstimmung (Pretune) außen an den Innenleiter an geeigneten Positionen mehrere, jeweils über eine PIN-Diode (32, 33, 34) ein- und abschaltbare Trimmerkondensatoren (35, 36, 37) angeschlossen sind, daß außen an den Innenleiter außerdem mit einem Ende noch ein Trimmerkondensator (38) angeschlossen ist, an dessen anderem Ende eine durch eine Vorabstimmspannung gesteuerte, erste Varaktordiode (39) liegt und daß an den Innenleiter außen noch über eine Drosselinduktivität (40) eine zweite Varaktordiode (41) angeschlossen ist, die von der Regelspannung beaufschlagt wird.

12. Frequenzsynthesizer nach Anspruch 11,
**dadurch gekennzeichnet**,
daß die mechanische Abstimmung des Koaxialresonators mittels einer Abstimmschraube (48) erfolgt, die an einem den Außenleiter des Koaxialresonators bildenden Gehäuse (55) befestigt ist und mittels der ein mit dem Innenleiter integrierter Tauchkondensator hinsichtlich dessen Kapazität eingestellt wird.

13. Frequenzsynthesizer nach Anspruch 11 oder 12
**dadurch gekennzeichnet**,
daß der Schleifentiefpaß (18) als Durchführungsfilter (42) Teil des als Baugruppe (43) ausgeführten spannungsgesteuerten Oszillators ist.

14. Frequenzsynthesizer nach einem der Ansprüche 11 bis 13,
**dadurch gekennzeichnet**,
daß der zusammen mit der Abstimmschraube (48) den Tauchkondensator bildende Innenleiter (29) temperaturkompensierend ausgebildet ist, z.B. durch eine Ausführung aus Invar.

15. Frequenzsynthesizer nach einem der vorhergehenden Ansprüche,
**gekennzeichnet durch**
eine Verwendung in einem frequenzagilen Radargerät.

## Claims

1. Frequency synthesizer for generating different frequencies in the microwave range, having a reference frequency branch and one or more phase-controlled control circuits, which are cascaded according to the frequency divide and mix principle and which form in each instance a PLL segment and exhibit an offset mixing stage for mixing a stable offset frequency with a reference frequency derived in the reference frequency branch from a stable quartz oscillator fundamental frequency, a phase frequency detector for comparing an error signal with a frequency likewise derived from the stable fundamental frequency and a voltage-controlled oscillator, to which the output voltage of the phase frequency discriminator is fed as control voltage via a loop low-pass filter and from which the output frequency as well as, possibly after being conducted through a frequency divider, the offset frequency for the phase-controlled control circuit of the next following PLL segment is derived, characterized in that, following the quartz oscillator (2) generating the stable fundamental frequency, the reference frequency branch (1) exhibits, in series, a first frequency multiplier (3), a quartz filter (4), one or more further frequency multipliers (5, 6) connected in series and a narrow-band band-pass filter (7) dimensioned for the reference frequency, in that to the output of the offset mixing stage (8) there is connected the input of a band-pass filter (9), which is designed either for the aggregate frequency or the difference frequency and the output of which is connected to one of the two inputs of an intermediate frequency mixing stage, to the other input of which the output signal of the voltage-controlled oscillator (11) is fed, in that the output of the intermediate frequency mixing stage is connected with interposition of an intermediate frequency filter (12) directly or via a frequency multiplier (13) to an input, representing the intermediate frequency input, of a screen mixing stage (14), at the other input of which a signal, which is filtered out from a comb line spectrum derived from the quartz oscillator (2) or a screen oscillator (49) by means of a comb line generator (15), with a spectral line spacing corresponding to the fundamental frequency, is present, in that from the output of the screen mixing stage the error signal oscillating at a synchronous intermediate frequency level with the mixed frequency of the signals fed to the screen mixing stage, is fed as first input signal to the one input and a reference signal, which is derived from the quartz oscillator via a frequency divider and which thus has a rigid division ratio with respect to the fundamental frequency or the screen oscillator frequency is fed to the second input of the phase frequency detector (17) for comparison, and in that the voltage-controlled oscillator, to which the output voltage, arising on account of the comparison, of the phase frequency detector is fed as control voltage via the loop low-pass filter (18), is designed to be pretunable, in such a manner that the one of the comb line frequencies onto which the screen mixing stage is to lock in each instance may be preset.

2. Frequency synthesizer according to Claim 1, characterized in that the offset frequency is generated by a direct digital synthesizer, instead of being generated by way of derivation via a PLL segment (19).

3. Frequency synthesizer according to Claim 1 or 2, characterized in that all PLL segments (19) are of identical construction.

4. Frequency synthesizer according to one of the preceding claims, characterized in that the division ratio of the frequency dividers (20) is 1:10 for the phase-controlled control circuits, which are cascaded in conformity with the frequency divide and mix principle, so that a decadic frequency synthesizer is obtained, in which each PLL segment (19) thus realizes one decimal place.

5. Frequency synthesizer according to one of the preceding claims, characterized in that the loop low-pass filter (18) is preceded by a variable-gain amplifier (21) the gain of which is presettable (pretunable).

6. Frequency synthesizer according to one of the preceding claims, characterized in that, where the intermediate frequency signal coincides with the error signal in terms of frequency, said intermediate frequency signal is conducted directly, i.e. without introduction into the intermediate frequency input of the screen mixing stage (14), to the first input of the phase frequency detector (17).

7. Frequency synthesizer according to one of the preceding claims, characterized in that the output signal of the voltage-controlled oscillator (11) is conducted in each instance further via one or more frequency multipliers (22, 23, 24) which are connected in parallel with one another, so that carrier frequencies in higher frequency bands can be generated.

8. Frequency synthesizer according to one of the preceding claims, characterized in that in the reference frequency branch (1) the first frequency multiplier (3) is a frequency doubler.

9. Frequency synthesizer according to one of the preceding claims, characterized in that in the reference frequency branch (1) following the quartz filter (4) two further frequency multipliers (5, 6) are provided, which are designed in each instance as frequency triplers.

10. Frequency synthesizer according to one of the preceding claims, characterized in that a high frequency amplifier (25) is further connected as isolating amplifier in the path of the supply of the output signal of the voltage-controlled oscillator (11) to the intermediate frequency mixing stage (10).

11. Frequency synthesizer according to one of the preceding claims, characterized in that the voltage-controlled oscillator (11) is a circuit which exhibits a monolithically integrated high frequency amplifier (26) and in the co-coupling branch of which, which leads from the output to the input of said circuit, and which forms a resonant circuit, there are situated in series a capacitor (27), a coaxial resonator which is coupled via an inductive in-coupling loop (28) and which is designed to be mechanically tunable, having an inner conductor (29), and a further capacitor (31) which is coupled to the inner conductor via an out-coupling loop (30), in that for the electronic pretuning a plurality of trimmer capacitors (35, 36, 37) which can be energized and de-energized in each instance via a PIN diode (32, 33, 34) are connected externally to the inner conductor at suitable positions, in that there is furthermore connected externally to the inner conductor by one end, a further trimmer capacitor (38), at the other end of which a first varactor diode (39) controlled by a pretuning voltage is situated, and in that there is further connected externally to the inner conductor via a choke inductance (40) a second varactor diode (41), which receives the control voltage.

12. Frequency synthesizer according to Claim 11, characterized in that the mechanical tuning of the coaxial resonator takes place by means of a tuning screw (48), which is secured to a housing (55) forming the outer conductor of the coaxial resonator, and by means of which a plunger-type capacitor integrated with the inner conductor is set with respect to its capacitance.

13. Frequency synthesizer according to Claim 11 or 12, characterized in that the loop low-pass filter (18), as feed-through filter (42), is part of the voltage-controlled oscillator which is constructed as assembly (43).

14. Frequency synthesizer according to one of Claims 11 to 13, characterized in that the inner conductor (29) forming, together with the tuning screw (48), the plunger-type capacitor, is designed to be temperature-compensating, e.g. by a construction from Invar.

15. Frequency synthesizer according to one of the preceding claims, characterized by a use in a frequency-agile radar system.

## Revendications

1. Synthétiseur de fréquence servant à produire différentes fréquences dans la gamme des micro-ondes, comportant une branche à fréquence de référence et un ou plusieurs circuits de régulation commandés du point de vue de la phase, qui sont branchés en cascade selon le principe "division de fréquence et mélange de fréquence" (divide and mix) et qui forment respectivement un segment de boucle PLL, et un étage mélangeur d'offset servant à mélanger une fréquence d'offset stable à une fréquence de référence, qui est obtenue, dans la branche à la fréquence de référence, à partir d'une fréquence de base stable de l'oscillateur à quartz, un détecteur de base et de fréquence servant à comparer un signal d'erreur à une fréquence également dérivée de la fréquence de base stable, et un oscillateur commandé par la tension, et auquel la tension de sortie du discriminateur de phase - fréquence est envoyée en tant que tension de régulation par l'intermédiaire d'un filtre passe-bas en boucle et à partir duquel sont dérivées la fréquence de sortie ainsi que, éventuellement, après passage dans un diviseur de fréquence, la fréquence d'offset pour le circuit de régulation commandé du point de vue de la phase, du segment de boucle PLL immédiatement suivant, caractérisé par le fait
que la branche (1) de la fréquence de référence possède, en aval de l'oscillateur à quartz (2) qui produit la fréquence de base stable, successivement un premier multiplicateur de fréquence (3), un filtre à quartz (4), un ou plusieurs autres multiplicateurs de fréquence (5,6) branchés en série, et un filtre passe-bande (7) à bande étroite, dimensionné pour la fréquence de référence, qu'à la sortie de l'étage mélangeur d'offset (8) est raccordée l'entrée d'un filtre passe-bande (9), qui est conçu soit pour la fréquence somme soit pour la fréquence différentielle et dont la sortie est reliée à l'une des deux entrées d'un étage mélangeur à fréquence intermédiaire, à l'autre entrée duquel est envoyé le signal de sortie de l'oscillateur (11) commandé par la tension, que la sortie de l'étage mélangeur à fréquence intermédiaire est reliée, moyennant le montage intercalé d'un filtre de fréquence intermédiaire (12), directement par l'intermédiaire d'un multiplicateur de fréquence (13), à une entrée, qui représente l'entrée à fréquence intermédiaire, d'un étage mélangeur de trame (14), à l'autre entrée duquel est appliqué un signal qui est séparé par filtrage d'un spectre de raies en peigne dérivé de l'oscillateur à quartz (2) ou d'un oscillateur de trame (49) au moyen d'un générateur de raies en peigne (15) et dans lequel la distance entre les raies spectrales correspond à la fréquence de base, que le signal d'erreur, qui oscille à la fréquence de mélange des signaux envoyés à l'étage mélangeur de trame, dans un plan synchrone de fréquences intermédiaires est envoyé par la sortie de l'étage mélangeur de trame en tant que premier signal d'entrée à une entrée du détecteur de phase - fréquence (17) et qu'un signal de référence, qui est tiré de l'oscillateur à quartz par l'intermédiaire d'un diviseur de fréquence et se situe par conséquent dans un rapport de division fixe par rapport à la fréquence de base ou à la fréquence de l'oscillateur de trame, est envoyé à la seconde entrée du détecteur de phase - fréquence (17) à des fins de comparaison, et que l'oscillateur commandé par la tension, auquel la tension de sortie, qui résulte de la comparaison, du détecteur de phase et de fréquence est envoyée en tant que tension de régulation par l'intermédiaire d'un filtre passe-bas en boucle (18), est réalisé de manière à pouvoir être pré-accordable (pretune) de sorte que celle des fréquences des raies en peigne, sur laquelle l'étage mélangeur de trame doit respectivement s'accrocher, peut être préréglée.

2. Synthétiseur de fréquence suivant la revendication 1, caractérisé par le fait que la fréquence d'offset peut être produite au lieu de cela lors de son obtention par l'intermédiaire d'un segment de boucle PLL (19), par un synthétiseur numérique direct.

3. Synthétiseur de fréquence suivant la revendication 1 ou 2, caractérisé par le fait que tous les segments de boucle PLL (19) sont agencés de la même manière.

4. Synthétiseur de fréquence suivant l'une des revendications précédentes, caractérisé par le fait que le rapport de division des diviseurs de fréquence (20) pour les circuits de régulation commandés du point de vue de la phase et branchés en cascade conformément au principe "division et mélange de fréquence" (divide and mix) est égal à 1:10 de sorte qu'on obtient un synthétiseur de fréquence décadique, dans lequel par conséquent chaque segment de boucle PLL (19) fournit un chiffre décimal.

5. Synthétiseur de fréquence suivant l'une des revendications précédentes, caractérisé par le fait qu'un amplificateur de régulation (21), dont l'amplification peut être préréglée (pretune), est branché en amont du filtre passe-bas en boucle (18).

6. Synthétiseur de fréquence suivant l'une des revendications précédentes, caractérisé par le fait que dans le cas où la fréquence du signal de fréquence intermédiaire coïncide avec le signal d'erreur, ce signal est envoyé directement, c'est-à-dire sans être introduit à l'entrée de fréquence intermédiaire de l'étage mélangeur de trame (14), à la première entrée du détecteur de phase - fréquence (17).

7. Synthétiseur de fréquence suivant l'une des revendications précédentes, caractérisé par le fait que le signal de sortie de l'oscillateur commandé par la tension (11) est respectivement envoyé encore par l'intermédiaire d'un ou de plusieurs multiplicateurs de fréquence (22,23,24) branchés en parallèle avec l'oscillateur, de sorte que l'on eut obtenir des fréquences porteuses situées dans des gammes de fréquences supérieures.

8. Synthétiseur de fréquence suivant l'une des revendications précédentes, caractérisé par le fait que le premier multiplicateur de fréquence (3) est un doubleur de fréquence situé dans la branche (1) fournissant la fréquence de référence.

9. Synthétiseur de fréquence suivant l'une des revendications précédentes, caractérisé par le fait que dans la branche à la fréquence de référence (1) sont disposés, en aval du filtre à quartz (4), deux autres multiplicateurs de fréquence (5,6), qui sont réalisés respectivement sous la forme de tripleurs de fréquence.

10. Synthétiseur de fréquence suivant l'une des revendications précédentes, caractérisé par le fait que sur le trajet de transmission du signal de sortie de l'oscillateur commandé par la tension (11) jusqu'à l'étage mélangeur de fréquence (10) est en outre prévu un amplificateur à haute fréquence (25) en tant qu'amplificateur séparateur.

11. Synthétiseur de fréquence suivant l'une des revendications précédentes, caractérisé par le fait que l'oscillateur (11) commandé par la tension est un circuit qui possède un amplificateur à haute fréquence intégré de façon monolithique (26), que dans la branche de réaction qui relie la sortie à l'entrée de ce circuit et qui forme un circuit résonant, sont branchés en série un condensateur (27), un résonateur coaxial agencé de manière à être raccordé mécaniquement, et accouplé par l'intermédiaire d'une boucle de couplage inductive (28) et comportant un conducteur intérieur (29) et un autre condensateur (31) accouplé au conducteur intérieur par l'intermédiaire d'une boucle de découplage (30), que pour le préaccord électronique (pretune), au conducteur intérieur sont raccordés extérieurement, en des positions appropriées, plusieurs condensateurs de réglage d'accord (35,36,37), qui peuvent être branchés et débranchés respectivement par l'intermédiaire d'une diode PIN (32,33,34), qu'en outre à une extrémité du conducteur intérieur est raccordé extérieurement un condensateur de réglage d'accord (38), à l'autre extrémité duquel est raccordée une première diode varactor (39), qui est commandée par une tension de préréglage d'accord et qu'au conducteur intérieur est en outre raccordée, de l'extérieur, et par l'intermédiaire d'une réactance inductive (40), une seconde diode varactor (40), qui est chargée par la tension de régulation.

12. Synthétiseur de fréquence suivant la revendication 11, caractérisé par le fait que l'accord mécanique du résonateur coaxial s'effectue à l'aide d'une vis de réglage d'accord (38), qui est fixée au boîtier (55), qui forme le conducteur extérieur du résonateur coaxial, et dont la capacité est réglée au moyen du condensateur à immersion, intégré au conducteur intérieur.

13. Synthétiseur de fréquence suivant la revendication 11 et 12, caractérisé que le filtre passe-bas de boucle (18) agencé en tant que filtre à traversée (42) fait partie de l'oscillateur commandé par la tension, qui est réalisé sous la forme d'un module (43).

14. Synthétiseur de fréquence suivant l'une des revendications 11 à 13, caractérisé par le fait que le conducteur intérieur (29) qui, conjointement avec la vis de réglage d'accord (48), forme le condensateur à immersion, est agencé de manière à réaliser une compensation de la température, par exemple en étant réalisé en invar.

15. Synthétiseur de fréquence suivant l'une des revendications précédentes, caractérisé par son utilisation dans un appareil radar agile en fréquence.
